# EUROPEAN PATENT APPLICATION

(11) **EP 2 613 345 A1**
(43) Date of publication of application: **10.07.2013**
(21) Application number: 11821468.3
(22) Date of filing: 26.07.2011
(51) Int. Cl.: H01L 21/308, H01L 21/28, H01L 21/306, H01L 21/336, H01L 29/423, H01L 29/49, H01L 29/78

(54) **SILICON ETCHANT AND METHOD FOR PRODUCING TRANSISTOR BY USING SAME**

(30) Priority: 31.08.2010 JP 2010194389
(71) Applicant: Mitsubishi Gas Chemical Company, Inc., Tokyo 100-8324 (JP)
(72) Inventor: SHIMADA, Kenji, Tokyo 125-0051 (JP); MATSUNAGA, Hiroshi, Tokyo 125-0051 (JP)
(74) Representative: Müller-Boré & Partner Patentanwälte
(86) International application number: PCT/JP2011/066997
(87) International publication number: WO 2012/029450

(57) **Abstract**

According to the present invention, there is provided an etching solution used for selectively etching a dummy gate made of silicon in a process for producing a transistor including a laminate formed of at least a high dielectric material film and an aluminum metal gate by the method of removing the dummy gate made of silicon to replace the dummy gate with the aluminum metal gate, and a process for producing a transistor using the etching solution. The present invention relates to a silicon etching solution used for etching the dummy gate made of silicon which includes 0.1 to 40% by weight of at least one alkali compound selected from the group consisting of ammonia, a diamine and a polyamine represented by the general formula (1), 5 to 50% by weight of at least one polyhydric alcohol represented by the general formula (2) and 40 to 94.9% by weight of water, and a process for producing a transistor using the silicon etching solution.

## Description

### TECHNICAL FIELD

The present invention relates to an etching solution used for selectively etching a dummy gate made of silicon in a process for producing a transistor using a structural body including a dummy gate laminate formed by laminating at least a high dielectric material film and the dummy gate made of silicon in which the dummy gate is replaced with an aluminum metal gate, and a process for producing a transistor using the etching solution.

### BACKGROUND ART

Hitherto, semiconductors have been continuously improved in performance, costs and power consumption by reduction of a gate length and a gate thickness of transistors, i.e., so-called micronization thereof. However, if it is intended to achieve the micronization of transistors as recently required, a gate thickness of a conventional gate insulating film using silicon oxide becomes excessively small, so that a leakage current owing to a tunnel current increases, and power consumption becomes large. In addition, in recent years, there is an increasing demand for mobile equipments using semiconductor devices such as mobile phones, notebook type personal computers and potable music players. In this case, a power supply for these mobile equipments has been frequently relied upon rechargeable batteries. Therefore, it has been required that the semiconductor devices used in the mobile equipments have a low power consumption to achieve long-term use thereof. In consequence, for the purpose of reducing a leakage current during a stand-by state of the equipments, there has been proposed the technique in which as combination of an insulating material and a gate electrode as constituents of a transistor, combination of a high dielectric material and a metal gate is used in place of the conventional combination of silicone oxide and polysilicon. In the conventional technique, aluminum is selectively used as one of metals for the metal gate (Patent Document 1).

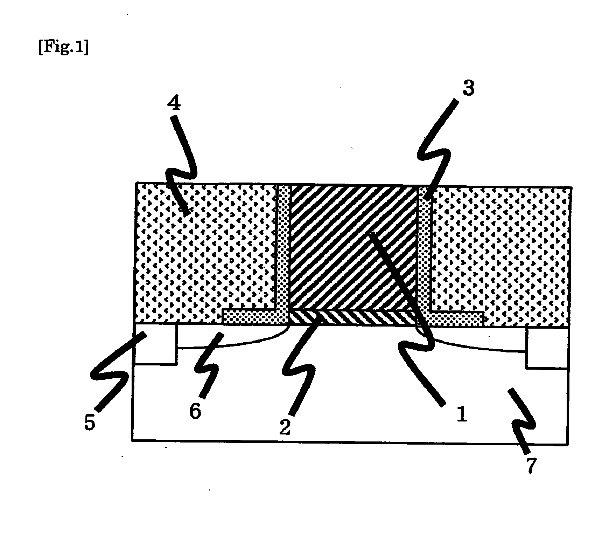

There have been conventionally proposed various methods for producing the high dielectric material and the metal gate. As one of the conventional methods, there has been proposed a so-called gate-last method in which after producing a transistor from combination of a high dielectric material and a polysilicon, the polysilicon is removed to replace it with a metal gate (Non-Patent Document 1). In FIG. 1, there is shown a schematic sectional view of a part of a transistor before removing a polysilicon from a semiconductor device using a high dielectric material. Upon etching the polysilicon, aluminum, an interlayer insulating film, a side wall and a high dielectric material film which are present around the polysilicon are portions which should not be removed by the etching. For these reasons, it is required to provide a technique of etching the polysilicon without removing the aluminum, interlayer insulating film, side wall and high dielectric material by the etching.

As a method of etching a polysilicon, there is also known the method of subjecting a polysilicon to dry etching (Patent Document 1). However, since aluminum and an interlayer insulating film are also etched in the dry etching process, it is necessary to provide a protective film such as a photoresist on the aluminum and interlayer insulating film. If such a protective film is formed, the production process tends to become complicated, so that there tend to arise the problems such as poor yield and increase in production costs. In addition, an ashing treatment required to remove the photoresist tends to cause damage to the aluminum and interlayer insulating film, which tends to cause a risk of deteriorating a performance of transistors. Also, in general, for the purpose of preventing generation of fine silicon residues, the silicon is subjected to so-called overetching in which the etching is carried out for a longer period of time than an etching treatment time calculated from an etching amount of silicon per unit time (hereinafter referred to as an "etch rate"). In the dry-etching process, a high dielectric material exposed after etching the silicon tends to be etched or tends to be deteriorated in quality when subjected to the overetching, resulting in deterioration in performance of transistors.

As a cleaning solution used upon etching silicon by a wet etching method, there are known various alkaline cleaning solutions (Non-Patent Document 2). However, these cleaning solutions tend to etch not only the polysilicon but also aluminum (refer to Comparative Examples 1).

As a technique of etching silicon without etching aluminum, there has been proposed the etching solution for anisotropic etching of silicon which is prepared by dissolving silicon in tetramethyl ammonium hydroxide (Patent Document 2). However, in this technique, the etching solution must be used at an elevated temperature. Therefore, when the above technique is carried out using a sheet cleaning apparatus for cleaning a silicon wafer one by one which has been recently used usually in production of semiconductors to suppress generation of particles in a wet etching method, it is not possible to attain a stable etching capability. If the etching is conducted at a temperature at which the sheet cleaning apparatus is usable, the etch rate of silicon tends to be excessively low. Thus, the above technique is not applicable to etching of silicon in a step of forming a transistor including a high dielectric material and a metal gate. In addition, in the above technique, precipitates are produced at a reduced temperature. For this reason, the technique is not applicable to a step of forming a transistor portion of semiconductors in which even fine particle residues are not allowed to remain. In addition, the technique is unsatisfactory to be used in a step of forming a transistor in a semiconductor in which etching of even a slight amount of aluminum should not be allowed (refer to Comparative Example 2).

As an etching agent composition capable of selectively etching silicon only by anisotropic etching thereof without etching aluminum or aluminum alloys, there has been proposed the alkali-based etching agent composition prepared by adding a reducing compound and an anticorrosive agent to an alkali aqueous solution (Patent Document 3). However, in this technique, since an etch rate of aluminum is excessively high, the technique is not applicable to etching of silicon in a step of forming a transistor including a high dielectric material and a metal gate (refer to Comparative Example 3).

As a technique for removing chlorine while suppressing etching of aluminum, there has been proposed the aqueous solution containing quaternary ammonium hydroxide, and a sugar or a sugar alcohol (Patent Document 4). However, the technique described in Patent Document 4 relates to the method of preventing etching of aluminum from the viewpoint of removal of chlorine, and therefore fails to specify a silicon etching capability of the alkaline stripping solution. More specifically, the technique described in Patent Document 4 is concerned with a technical concept which is quite different from that of the present invention which aims at etching silicon without etching an aluminum film. Further, the aqueous solution described in Patent Document 4 which has an excessively low silicon etch rate is not usable in etching of silicon in the step of forming a transistor including a high dielectric material and a metal gate as aimed by the present invention (refer to Comparative Examples 4).

There has also been proposed the stripping solution which is capable of suppressing etching of aluminum and reducing an adhesion strength of an adhesive film (Patent Document 5). However, in the technique proposed in Patent Document 5, etching of aluminum with the alkaline stripping solution is prevented from such a viewpoint that its capability of reducing an adhesion strength of the adhesive film is not inhibited. Thus, Patent Document 5 fails to describe a silicon etching capability of the alkaline stripping solution. Therefore, the technique described in Patent Document 5 is different from that of the present invention which aims at etching silicon without etching an aluminum film. Further, in Patent Document 5, it is described that the stripping solution used therein is not particularly limited as long as it is in the form of an alkaline solution. However, alkaline compounds capable of etching silicon are limited to specific compounds. Thus, the compounds suitably used in the present invention are not easily suggested from the descriptions of the Patent Document 5 (refer to Comparative Examples 5).

As a technique of suppressing etching of aluminum and removing a polyimide orientation film, there has been proposed the aqueous solution containing quaternary ammonium hydroxide, trialkylamine, and an alcohol or an alkyl ether (Patent Document 6). However, the cleaning solution has a low silicon etching capability and therefore is unsuitable for achieving the object as aimed by the present invention (refer to Comparative Examples 6).

In consequence, in the process for producing a transistor including a laminate formed of at least a high dielectric material film and an aluminum metal gate by a method of removing a dummy gate made of silicon to replace the dummy gate with the aluminum metal gate, it has been intensively demanded to provide an etching solution which is capable of selectively removing the dummy gate by etching.

### Prior Art Documents

### Patent Documents

Patent Document 1: USP No. 7316949
Patent Document 2: JP 4-370932A
Patent Document 3: JP 2007-214456A
Patent Document 4: JP 4-48633A
Patent Document 5: JP 2005-229053A
Patent Document 6: JP 2006-8932A

### Non-Patent Documents

Non-Patent Document 1: "Applied Physics", 76, 9, 2007, p. 1006
Non-Patent Document 2: "Complete Collection of Micro-Machine/MEMS Technologies", 2003, p. 111

### BRIEF DESCRIPTION OF THE DRAWING

FIG. 1 is a sectional view of a transistor using a high dielectric material before removing silicon therefrom.

### Explanation of Reference Numerals

1: Dummy gate (silicon); 2: High dielectric material film; 3: Side wall; 4: Interlayer insulating film; 5: Isolation; 6: Source/drain; 7: Substrate

### DISCLOSURE OF THE INVENTION

### Problem to be Solved by the Invention

An object of the present invention is to provide an etching solution for selectively etching a dummy gate made of silicon in a process for producing a transistor including a laminate formed of at least a high dielectric material film and an aluminum metal gate by the method of removing the dummy gate made of silicon to replace the dummy gate with the aluminum metal gate, and a process for producing a transistor using the etching solution.

### Means for Solving the Problem:

As a result of an earnest study for achieving the above object, the present inventors have found that the above object of the present invention can be achieved by using a specific silicon etching solution for etching a dummy gate made of silicon. The present invention has been accomplished on the basis of the above finding. That is, the present invention provides the following aspects:

1. A silicon etching solution for etching a dummy gate made of silicon in a process for producing a transistor using a structural body including a substrate, and a dummy gate laminate formed by laminating at least a high dielectric material film and the dummy gate made of silicon, a side wall disposed to cover a side surface of the laminate and an interlayer insulating film disposed to cover the side wall which are provided on the substrate, in which the dummy gate is replaced with an aluminum metal gate,
   said silicon etching solution including 0.1 to 40% by weight of at least one alkali compound selected from the group consisting of ammonia, a diamine and a polyamine represented by the following general formula (1), 5 to 50% by weight of at least one polyhydric alcohol represented by the following general formula (2) and 40 to 94.9% by weight of water:

   H₂N-(CH₂CH₂NH)ₘ-H (1)

   wherein m is an integer of 2 to 5; and

   H-(CH(OH))ₙ-H (2)

   wherein n is an integer of 3 to 6.
2. The silicon etching solution as described in the above aspect 1, wherein the diamine and the polyamine represented by the general formula (1) are at least one compound selected from the group consisting of ethylenediamine, 1,2-propanediamine and 1,3-propanediamine, and at least one compound selected from the group consisting of diethylenetriamine and triethylenetetramine, respectively.
3. The silicon etching solution as described in the above aspect 1, wherein the polyhydric alcohol represented by the general formula (2) is at least one compound selected from the group consisting of glycerin, meso-erythritol, xylitol and sorbitol.
4. The silicon etching solution as described in the above aspect 1, wherein a high dielectric material forming the high dielectric material film is HfO₂, HfSiO, HfSiON, HfLaO, HfLaON, HfTiSiON, HfAlSiON, HfZrO or Al₂O₃.
5. A process for producing a transistor using a structural body including a substrate, and a dummy gate laminate formed by laminating at least a high dielectric material film and a dummy gate made of silicon, a side wall disposed to cover a side surface of the laminate and an interlayer insulating film disposed to cover the side wall which are provided on the substrate,
   said process including the following step (I) so that the dummy gate is replaced with an aluminum metal gate:
   Step (I): etching the silicon with an etching solution including 0.1 to 40% by weight of at least one alkali compound selected from the group consisting of ammonia, a diamine and a polyamine represented by the following general formula (1), 5 to 50% by weight of at least one polyhydric alcohol represented by the following general formula (2) and 40 to 94.9% by weight of water:

      H₂N-(CH₂CH₂NH)ₘ-H (1)

      wherein m is an integer of 2 to 5; and

      H-(CH(OH))ₙ-H (2)

      wherein n is an integer of 3 to 6.
6. The process for producing a transistor as described in the above aspect 5, wherein a high dielectric material forming the high dielectric material film is HfO₂, HfSiO, HfSiON, HfLaO, HfLaON, HfTiSiON, HfAlSiON, HfZrO or Al₂O₃.
7. The process for producing a transistor as described in the above aspect 5, wherein the diamine and the polyamine represented by the general formula (1) are at least one compound selected from the group consisting of ethylenediamine, 1,2-propanediamine and 1,3-propanediamine, and at least one compound selected from the group consisting of diethylenetriamine and triethylenetetramine, respectively.
8. The process for producing a transistor as described in the above aspect 5, wherein the polyhydric alcohol represented by the general formula (2) is at least one compound selected from the group consisting of glycerin, meso-erythritol, xylitol and sorbitol.

### EFFECT OF THE INVENTION

According to the present invention, in a process for producing a transistor including a laminate formed of at least a high dielectric material film and an aluminum metal gate by the method in which a dummy gate made of silicon is removed and replaced with the aluminum metal gate, it is possible to selectively remove the silicon by etching. As a result, according to the present invention, it is possible to produce a transistor having a high precision and a high quality with a high yield.

### PREFERRED EMBODIMENTS FOR CARRYING OUT THE INVENTION

### [Silicon Etching Solution]

The silicon etching solution according to the present invention is used for etching a dummy gate made of silicon in a process for producing a transistor using a structural body which includes a substrate, and a dummy gate laminate formed by laminating at least a high dielectric material film and the dummy gate made of silicon, a side wall disposed to cover a side surface of the laminate and an interlayer insulating film disposed to cover the side wall which are provided on the substrate, such that the dummy gate is replaced with an aluminum metal gate. The silicon etching solution includes 0.1 to 40% by weight of at least one alkali compound selected from the group consisting of ammonia, a diamine and a polyamine represented by the following general formula (1), 5 to 50% by weight of at least one polyhydric alcohol represented by the following general formula (2) and 40 to 94.9% by weight of water,

H₂N-(CH₂CH₂NH)ₘ-H (1)

wherein m is an integer of 2 to 5; and

H-(CH(OH))ₙ-H (2)

wherein n is an integer of 3 to 6.

The alkali compound used in the present invention serves for etching silicon, and is at least one compound selected from the group consisting of ammonia, a diamine and a polyamine represented by the general formula (1). Examples of the preferred diamine contained in the silicon etching solution according to the present invention include ethylenediamine, 1,2-propanediamine and 1,3-propanediamine. Examples of the preferred polyamine represented by the general formula (1) include diethylenetriamine and triethylenetetramine.
The concentration of the alkali compound in the etching solution is usually from 0.1 to 40% by weight, preferably from 0.2 to 40% by weight and more preferably from 0.3 to 30% by weight.

The polyhydric alcohol contained in the silicon etching solution according to the present invention is at least one compound selected from the group consisting of those compounds represented by the general formula (2). Specific examples of the preferred polyhydric alcohol represented by the general formula (2) include glycerin, meso-erythritol, xylitol and sorbitol.
The concentration of the polyhydric alcohol in the etching solution is usually from 5 to 50% by weight, preferably from 6 to 40% by weight and more preferably from 7 to 30% by weight. When the concentration of the polyhydric alcohol in the etching solution is 5% by weight or more, the resulting etching solution can exhibit a sufficient effect of preventing corrosion of aluminum. On the other hand, when the concentration of the polyhydric alcohol in the etching solution is 50% by weight or less, the resulting etching solution can exhibit a sufficient silicon etching capability.

The silicon etching solution according to the present invention may further contain various additives ordinarily used in conventional etching solutions such as a surfactant and an anticorrosive agent, unless the addition of these additives causes any adverse influence on the objects and effects of the present invention.

### «Structural Body»

The silicon etching solution according to present invention is used for etching a dummy gate made of silicon in a structural body which includes, on a substrate, a dummy gate laminate formed of a high dielectric material film and the dummy gate made of silicon, a side wall disposed to cover a side surface of the laminate, and an interlayer insulating film disposed to cover the side wall. In FIG. 1, there is shown a sectional view of the structural body with the dummy gate to be etched with the etching solution according to the present invention. The structural body shown in FIG. 1 is provided on a substrate 7 with a dummy gate laminate formed by laminating a high dielectric material film 2 and a dummy gate 1 made of silicon, a side wall 3 disposed to cover a side surface of the laminate, and an interlayer insulating film 4 disposed to cover the side wall 3.

Although not shown in FIG. 1, the structural body may have a portion in which the dummy gate 1 has been already replaced with an aluminum metal gate. The aluminum metal gate as used herein means a metal gate containing metallic aluminum, and is not necessarily formed of 100% of aluminum. From the viewpoint of sufficiently attaining the effects of the present invention, the content of aluminum in the aluminum metal gate is preferably 50% or more. Further, either a whole or a part of the dummy gate may be replaced with the aluminum metal gate. In the present invention, as far as aluminum is used only as a part of the transistor, it is possible to exhibit the effect of selectively etching silicon forming the dummy gate without etching the aluminum portion.
In addition, in FIG. 1, there are shown a source/drain region 6 and an isolation 5 which may be formed by a suitable method such as ion implantation. The high dielectric material film 2 is usually provided on the substrate 7 so as to cover a portion between the adjacent source/drain regions 6.

In the structural body to be treated with the etching solution according to the present invention, as the material for the substrate 7, there are preferably used silicon, amorphous silicon, polysilicon and glass. As the wiring material for the metal gate, etc., there is used at least aluminum, and there may also be used wiring materials other than aluminum such as, for example, copper, tungsten, titanium-tungsten, aluminum, aluminum alloys, chromium and chromium alloys.
Examples of the preferred material for the interlayer insulating film 4 include silicon oxide films obtained by a high-density plasma chemical vapor deposition method (HDP), tetraethoxysilane (TEOS) and boron phosphor silicate glass (BPSG). Examples of the preferred material for the side wall 3 include silicon nitride (SiN), etc. Examples of the preferred high dielectric material include HfO₂, Al₂O₃ and materials containing a silicon atom and/or a nitrogen atom and/or a metal such as La, Ti and Zr in addition to HfO₂ and Al₂O₃. However, the materials used for the interlayer insulating film 4, the side wall 3 and the high dielectric material film 2 are not particularly limited to the above materials.

As recognized from FIG. 1, when etching the dummy gate 1 made of silicon, the silicon etching solution according to the present invention is first allowed to come into contact with the aluminum metal gate (not shown), the interlayer insulating film 4 and the side wall 3 in the structural body. Further, as etching of the dummy gate 1 proceeds, the underlying high dielectric material film 2 being present underneath the dummy date 1 is exposed to outside and therefore the etching solution comes into contact with the high dielectric material film 2. Under the circumstances, by using the silicon etching solution according to the present invention which is capable of selectively etching the dummy gate 1 made of silicon without etching the aluminum metal gate (not shown), the interlayer insulating film 4 and the side wall 3 as well as the high dielectric material film 2, it is possible to produce a transistor having a high precision and a high quality with a high yield while preventing damage to the respective portions of the transistor.

### «Etching of Dummy Gate>>

The temperature of the silicon etching solution according to the present invention when used, i.e., the temperature used upon etching the dummy gate, is usually from about 20 to about 80°C, preferably from 20 to 70°C and more preferably from 20 to 60°C. The temperature of the etching solution upon use may be appropriately determined according to etching conditions or material of the substrate used.

The treating time upon the etching treatment with the silicon etching solution according to the present invention, i.e., the time required for etching the dummy gate, is usually in the range of from about 0.1 to about 10 min, preferably from 0.2 to 8 min and more preferably from 0.3 to 5 min, and may be appropriately determined according to etching conditions or material of the substrate used.

### [Process for Producing Transistor]

The process for producing a transistor according to the present invention is characterized by using a structural body which includes a substrate, and a dummy gate laminate formed by laminating at least a high dielectric material film and a dummy gate made of silicon, a side wall disposed to cover a side surface of the laminate and an interlayer insulating film disposed to cover the side wall which are provided on the substrate, and including the step of etching the silicon with an etching solution containing 0.1 to 40% by weight of at least one alkali compound selected from the group consisting of ammonia, a diamine and a polyamine represented by the following general formula (1), 5 to 50% by weight of at least one polyhydric alcohol represented by the following general formula (2) and 40 to 94.9% by weight of water, namely, the etching solution according to the present invention, and thereby replacing the dummy gate with an aluminum metal gate:

H₂N-(CH₂CH₂NH)ₘ-H (1)

wherein m is an integer of 2 to 5; and

H-(CH(OH))ₙ-H (2)

wherein n is an integer of 3 to 6.

In the process for producing a transistor according to the present invention, the structural body and the etching solution used therein are the same as described above. In addition, the temperature of the etching solution according to the present invention upon use as well as the treating time with the etching solution are also the same as described above.
In the etching step using the etching solution according to the present invention, an ultrasonic wave may be used in combination, if required. In addition, a rinsing solution used after removing etching residues on the substrate according to the production process of the present invention is not necessarily an organic solvent such as alcohols, and water may be satisfactorily used as the rinsing solution.

### <<Other Steps>>

The process for producing a transistor according to the present invention is not particularly limited to the above specific process as long as the process includes the etching step using the etching solution according to the present invention. The process for producing a transistor according to one preferred embodiment of the present invention includes a step (A) of forming a high dielectric material film on a substrate; a step (B) of forming a dummy gate made of silicon on the high dielectric material film to form a laminate containing the high dielectric material film and the dummy gate; a step (C) of forming a side wall to cover a side surface of the laminate; a step (D) of forming an interlayer insulating film to cover the side wall; a step (E) of etching a natural silicon oxide film; the above step (1) of etching the dummy gate using the etching solution according to the present invention; and a step (F) of forming an aluminum metal gate on the high dielectric material film to form a laminate containing the high dielectric material film and the aluminum metal gate. The steps (A) to (F) are not particularly limited and may be carried out by ordinary methods which may be generally adopted for respective steps in a process for production of transistors.

### <Etching of Natural Silicon Oxide Film (Step (E))>

As shown in FIG. 1, the dummy gate 1 is made of a silicon material such as polysilicon. The surface of the silicon material is subjected to natural oxidation owing to contact with air in the process for producing a transistor so that a natural silicon oxide film tends to be formed thereon. In consequence, in the production process of the present invention, before conducting the step of etching the dummy gate 1 using the etching solution according to the present invention (step (1)), the natural silicon oxide film 6 is preferably previously etched, so that it is possible to efficiently conduct the step of etching the dummy gate using the etching solution according to the present invention and therefore produce a transistor having a high precision and a high quality with a high yield.

In the step (E), in order to etch the natural silicon oxide film, there may be used conventionally used etching solutions, for example, those etching solutions containing a fluorine compound such as hydrofluoric acid. In addition, in the step (E), the etching solution is allowed to come into contact with the aluminum metal gate (not shown), the interlayer insulating film 4 and the side wall 3 in the structural body. Therefore, it is preferred to use an etching solution which is free from damage to these portions, i.e., an etching solution having a performance of selectively etching the natural silicon oxide film. As the etching solution capable of satisfying the above requirements, there is preferably used an etching solution including 0.01 to 8% by weight of a fluorine compound, 20 to 90% by weight of a water-soluble organic solvent and water.

Specific examples of the preferred fluorine compound include hydrofluoric acid, ammonium fluoride and acid ammonium fluoride. Among these fluorine compounds, more preferred are ammonium fluoride and acid ammonium fluoride. In the present invention, these fluorine compounds may be used alone or in combination of any two or more thereof.
As the water-soluble organic solvent, there are preferably used alcohols such as ethanol, 2-propanol, ethylene glycol and diethylene glycol; glycol ethers such as diethylene glycol monomethyl ether, diethylene glycol monobutyl ether, dipropylene glycol monomethyl ether and dipropylene glycol monopropyl ether; amides such as N,N-dimethylformamide, N,N-dimethylacetamide and N-methyl-2-pyrrolidone; and dimethyl sulfoxide. These water-soluble organic solvents may be used alone or in combination of any two or more thereof.
In addition, the etching solution used in the step (E) may also contain an inorganic acid such as hydrochloric acid, nitric acid, sulfuric acid and phosphoric acid; and an organic acid such as acetic acid, propionic acid, oxalic acid and methanesulfonic acid in an amount of about 5% by weight or less. These acids may be used alone or in combination of any two or more thereof.

### «Transistor»

The transistor obtained by the production process of the present invention includes a substrate 7, and a laminate formed by laminating at least a high dielectric material film 2 and an aluminum metal gate (not shown), a side wall 3 disposed to cover a side surface of the laminate and an interlayer insulating film 4 disposed to cover the side wall 3 which are provided on the substrate. More specifically, the transistor thus produced has a structure in which the dummy gate 1 in the structural body as shown in FIG. 1 to be subjected to the etching step using the etching solution according to the present invention is replaced with the aluminum metal gate. In addition, as shown in FIG. 1, the transistor obtained by the production process of the present invention further includes a source/drain region 6 and an isolation 5, and the high dielectric material film 2 is provided on a surface of the substrate 7 to cover a portion between the adjacent source/drain regions 6.

In the transistor obtained by the production process of the present invention, the material used for the substrate 7, the material used for the interlayer insulating film 4 and the material used for the side wall 3 are the same as the material used for the substrate 7, the material used for the interlayer insulating film 4 and the material used for the side wall 3 as described with respect to the above structural body, respectively.

The transistor obtained by the production process of the present invention may also include portions generally contained in transistors, for example, a barrier layer and an insulating film. Examples of a preferred barrier material forming the barrier layer include titanium, titanium nitride, tantalum and tantalum nitride. Examples of a preferred insulating material forming the insulating film include silicon oxide, silicon nitride, silicon carbide and derivatives of these compounds.
In the laminate formed by laminating the high dielectric material film 2 and the aluminum metal gate (not shown), there may also be provided an additional metal gate made of a metal material other than the metal forming the aluminum metal gate as well as a functional layer such as, for example, a characteristic-controlling film. Examples of the preferred semiconductor material used in the present invention include compound semiconductors such as gallium-arsenic, gallium-phosphorus and indium-phosphorus, and oxide semiconductors such as chromium oxide.
The transistor obtained by the production process of the present invention has a high precision and a high quality.

### EXAMPLES

The present invention will be described in more detail below by referring to the following examples. It should be noted, however, that the following examples are only illustrative and not intended to limit the invention thereto.

### Evaluation Method

### Measuring Equipments:

Fluorescent X-ray analysis: Measured using "SEA1200VX" available from SII Nano Technology Inc.
SEM observation: Observed using an ultrahigh resolution field emission type scanning electron microscope "S-5500" available from Hitachi Hi-Technologies Corp.
FIB Fabrication: Fabricated using a focused ion beam fabrication device "FB-2100" available from Hitachi Hi-Technologies Corp.
STEM Observation: Observed using a scanning transmission electron microscope "HD-2300" available from Hitachi Hi-Technologies Corp. Determination:

### (Etching Condition of Dummy Gate 1 Made of Silicon)

○: Dummy Gate 1 was completely etched.
× : Dummy Gate 1 was insufficiently etched.

### (Evaluation of Corrosion Resistance to Aluminum)

○: Etch rate of aluminum was less than 1 nm/min.
×: Etch rate of aluminum was not less than 1 nm/min.

### EXAMPLES 1 TO 48

In order to examine a corrosion resistance of the etching solution to aluminum, the following procedure was used. That is, a 1000 Å-thick aluminum film was deposited on a silicon wafer as a substrate by PVD. The aluminum film thus deposited on the substrate was immersed in the etching solution shown in Table 2 at 25°C for 30 min, and the thickness of the aluminum film before and after the immersion was measured by a fluorescent X-ray analyzer to calculate an amount of the aluminum film etched with the etching solution. Further, an etch rate of aluminum was calculated from the amount of the aluminum film etched and the immersion time. When the etch rate of aluminum is less than 1 nm/min, it was determined that the etching solution had a corrosion resistance to aluminum.

Next, testing methods for a silicon etching capability of the etching solution and a corrosion resistance thereof to the high dielectric material film, side wall and interlayer insulating film are explained. Using a silicon wafer as the substrate, there were prepared structural bodies each having a section as shown in FIG. 1 in which respective transistor structures represented by 1A to 1I in Table 1 were formed on the silicon wafer. In the respective Examples in which the respective structural bodies as shown in Table 3 were used, in order to remove a natural silicon oxide film being present on a surface of the dummy gate 1 made of silicon, the structural bodies thus prepared were immersed in a 0.05 wt% hydrofluoric acid etching solution at 25°C for 2 min, rinsed with ultrapure water and then dried by injecting a dry nitrogen gas thereto. Thereafter, the structural bodies were immersed in the respective etching solutions as shown in Table 3 (as to compositions of the respective etching solutions, refer to Table 2) at a predetermined temperature for a predetermined time, and then subjected to rinsing with ultrapure water and drying by injecting a dry nitrogen gas thereto.
After being etched, a section of the respective transistors was subjected to SEM observation to determine the conditions of the dummy gate 1 made of silicon, the side wall 3 and the interlayer insulating film 4.

The high dielectric material film 2 was covered with the dummy gate 1 made of silicon. Therefore, when the dummy gate 1 made of silicon was removed using the etching solution, the high dielectric material film 2 was allowed to come into contact with the etching solution. Thus, when observing the condition of the high dielectric material film 2, it was possible to determine whether or not any damage to the high dielectric material film by the etching solution was caused. In consequence, only in the case where the dummy gate 1 made of silicon was removed by the etching, the transistor obtained after the etching was subjected to thin film fabrication using FIB to form a thin film having a thickness of 200 nm or less, and the resulting thin film was observed by STEM to determine the condition of the high dielectric material film 2.

After being immersed in the etching solutions as shown in Table 2, it was confirmed that the side wall 3, the interlayer insulating film 4 and the high dielectric material film 2 were not etched. Therefore, in Tables 3 and 5, there are shown the evaluation results of the condition of the dummy gate 1 made of silicon as well as the etch rate of aluminum.

In Examples 1 to 48 to which the production process of the present invention using the respective etching solutions as shown in Table 2 was applied, it was confirmed that the etch rate of aluminum was less than 1 nm/min and the dummy gate 1 made of silicon was selectively etched as shown in Table 3.

### COMPARATIVE EXAMPLE 1

Using the structural body having the transistor structure 1D, the same procedure as in Example 1 was carried out except that after conducting the hydrofluoric acid treatment, the structural body was subjected to etching treatment using a 2 wt% tetramethyl ammonium hydroxide aqueous solution (etching solution 4A as shown in Table 4) as described in Non-Patent Document 2 in place of the etching solution 2G. As a result, as shown in Table 5, the etching solution was deficient in a capability of etching the dummy gate 1 made of silicon, and the etch rate of aluminum was 1 nm/min or more. From the above results, it was confirmed that the etching solution as described in Non-Patent Document 2 was inapplicable to removal of silicon by etching in the process for producing the transistor containing the high dielectric material and the aluminum-containing metal gate as aimed by the present invention.

### COMPARATIVE EXAMPLE 2

Using the structural body having the transistor structure 1B, the same procedure as in Example 1 was carried out except that after conducting the hydrofluoric acid treatment, the structural body was subjected to etching treatment using the aqueous solution containing 0.5% by weight of tetramethyl ammonium hydroxide and 0.1% by weight of silicon (etching solution 4B as shown in Table 4) as described in Patent Document 2 in place of the etching solution 2G. As a result, as shown in Table 5, although the etch rate of aluminum was less than 1 nm/min, the etching solution was deficient in a capability of etching the dummy gate 1 made of silicon. From the above results, it was confirmed that the etching solution as described in Patent Document 2 was inapplicable to removal of silicon by etching in the process for producing the transistor containing the high dielectric material and the metal gate as aimed by the present invention.

### COMPARATIVE EXAMPLE 3

Using the structural body having the transistor structure 1C, the same procedure as in Example 1 was carried out except that after conducting the hydrofluoric acid treatment, the structural body was subjected to etching treatment using the aqueous solution containing 10% by weight of tetramethyl ammonium hydroxide, 10% by weight of hydroxyl amine and 5% by weight of sorbitol (etching solution 4C as shown in Table 4) as described in Patent Document 3 in place of the etching solution 2G. As a result, as shown in Table 5, although the dummy gate 1 made of silicon was removed by etching, the etch rate of aluminum was 1 nm/min or more. From the above results, it was confirmed that the aqueous solution as described in Patent Document 3 was inapplicable to removal of silicon by etching in the process for producing the transistor containing the high dielectric material and the metal gate as aimed by the present invention.

### COMPARATIVE EXAMPLE 4

Using the structural body having the transistor structure 1G, the same procedure as in Example 1 was carried out except that after conducting the hydrofluoric acid treatment, the structural body was subjected to etching treatment using the aqueous solution containing 2.4% by weight of tetramethyl ammonium hydroxide and 5% by weight of sorbitol (etching solution 4D as shown in Table 4) as described in Patent Document 4 in place of the etching solution 2G. As a result, as shown in Table 5, the aqueous solution was deficient in a capability of etching the dummy gate 1 made of silicon, and the etch rate of aluminum was 1 nm/min or more. From the above results, it was confirmed that the aqueous solution as described in Patent Document 4 was inapplicable to removal of silicon by etching in the process for producing the transistor containing the high dielectric material and the metal gate as aimed by the present invention.

### COMPARATIVE EXAMPLE 5

Using the structural body having the transistor structure 1E, the same procedure as in Example 1 was carried out except that after conducting the hydrofluoric acid treatment, the structural body was subjected to etching treatment using the aqueous solution containing 5% by weight of hexamethylenediamine (1,6-hexanediamine) and 30% by weight of sorbitol (etching solution 4E as shown in Table 4) as described in Patent Document 5 in place of the etching solution 2G. As a result, as shown in Table 5, although the etch rate of aluminum was less than 1 nm/min, the aqueous solution was deficient in a capability of etching the dummy gate 1 made of silicon. From the above results, it was confirmed that the stripping solution as described in Patent Document 5 was inapplicable to removal of silicon by etching in the process for producing the transistor containing the high dielectric material and the metal gate as aimed by the present invention.

### COMPARATIVE EXAMPLE 6

Using the structural body having the transistor structure 1I, the same procedure as in Example 1 was carried out except that after conducting the hydrofluoric acid treatment, the structural body was subjected to etching treatment using the aqueous solution containing 4% by weight of tetramethyl ammonium hydroxide, 0.01% by weight of trimethylamine, 80% by weight of propylene glycol and 4% by weight of glycerin (etching solution 4F as shown in Table 4) as described in Patent Document 6 in place of the etching solution 2G. As a result, as shown in Table 5, although the etch rate of aluminum was less than 1 nm/min, the aqueous solution was deficient in a capability of etching the dummy gate 1 made of silicon. From the above results, it was confirmed that the aqueous solution as described in Patent Document 6 was inapplicable to removal of silicon by etching in the process for producing the transistor containing the high dielectric material and the metal gate as aimed by the present invention.

### COMPARATIVE EXAMPLE 7

Using the structural body having the transistor structure 1F, the same procedure as in Example 1 was carried out except that after conducting the hydrofluoric acid treatment, the structural body was subjected to etching treatment using a 0.5 wt% 1,3-propanediamine aqueous solution (etching solution 4G as shown in Table 4) in place of the etching solution 2G. As a result, as shown in Table 5, the aqueous solution was deficient in a capability of etching the dummy gate 1 made of silicon, and the etch rate of aluminum was 1 nm/min or more. From the above results, it was confirmed that the alkali compound aqueous solution was inapplicable to removal of silicon by etching in the process for producing the transistor containing the high dielectric material and the metal gate as aimed by the present invention.

### COMPARATIVE EXAMPLE 8

Using the structural body having the transistor structure 1H, the same procedure as in Example 1 was carried out except that after conducting the hydrofluoric acid treatment, the structural body was subjected to etching treatment using a 10 wt% sorbitol aqueous solution (etching solution 4H as shown in Table 4) in place of the etching solution 2G. As a result, as shown in Table 5, although the etch rate of aluminum was less than 1 nm/min, the aqueous solution was deficient in a capability of etching the dummy gate 1 made of silicon. From the above results, it was confirmed that the polyhydric alcohol aqueous solution was inapplicable to removal of silicon by etching in the process for producing the transistor containing the high dielectric material and the metal gate as aimed by the present invention.

### COMPARATIVE EXAMPLE 9

Using the structural body having the transistor structure 1A, the same procedure as in Example 1 was carried out except that after conducting the hydrofluoric acid treatment, the structural body was subjected to etching treatment using an aqueous solution containing 5% by weight of 1,3-propanediamine and 10% by weight of inositol (etching solution 4I as shown in Table 4) in place of the etching solution 2G. As a result, as shown in Table 5, although the dummy gate 1 made of silicon was removed by etching, the etch rate of aluminum was 1 nm/min or more. From the above results, it was confirmed that the aqueous solution containing the alkali compound and the cyclic polyhydric alcohol was inapplicable to removal of silicon by etching in the process for producing the transistor containing the high dielectric material and the metal gate as aimed by the present invention.

### COMPARATIVE EXAMPLE 10

Using the structural body having the transistor structure 1A, the same procedure as in Example 1 was carried out except that after conducting the hydrofluoric acid treatment, the structural body was subjected to etching treatment using an aqueous solution containing 5% by weight of 1,3-propanediamine and 10% by weight of sucrose (etching solution 4J as shown in Table 4) in place of the etching solution 2G. As a result, as shown in Table 5, although the dummy gate 1 made of silicon was removed by etching, the etch rate of aluminum was 1 nm/min or more. From the above results, it was confirmed that the aqueous solution containing the alkali compound and the non-reducing sugar was inapplicable to removal of silicon by etching in the process for producing the transistor containing the high dielectric material and the metal gate as aimed by the present invention.

**TABLE 1**

| Transistor structure | Materials | | |
|---|---|---|---|
| | High dielectric material 2 | Side wall 3 | Interlayer insulating film 4 |
| 1A | HfO₂ | SiN | HDP |
| 1B | HfSiO | SiN | HDP |
| 1C | HfSiON | SiN | HDP |
| 1D | HfLaO | SiN | TEOS |
| 1E | HfLaON | SiN | TEOS |
| 1F | HfTiSiON | SiN | TEOS |
| 1G | HfAlSiON | SiN | TEOS |
| 1H | HfZrO | SiN | TEOS |
| 1I | Al₂O₃ | SiN | BPSG |

| | | | |
|---|---|---|---|
| Note: HDP: Silicon oxide film produced by high-density plasma chemical method TEOS: Tetraethoxysilane BPSG: Boron phosphor silicate glass | | | |

**TABLE 2**

| Etching solution | Alkali | | Polyhydric alcohol | | Water |
|---|---|---|---|---|---|
| | Kind | Conc. (wt%) | Kind | Conc. (wt%) | Conc. (wt%) |
| 2A | Ammonia | 1 | Sorbitol | 10 | 89 |
| 2B | Ethylenediamine | 1 | Sorbitol | 10 | 89 |
| 2C | 1,2-Propanediamine | 1 | Glycerin | 30 | 69 |
| 2D | 1,3-Propanediamine | 1 | Meso-erythritol | 30 | 69 |
| 2E | 1,3-Propanediamine | 0.5 | Xylitol | 30 | 69.5 |
| 2F | 1,3-Propanediamine | 30 | Sorbitol | 10 | 60 |
| 2G | 1,3-Propanediamine | 5 | Xylitol | 40 | 55 |
| 2H | 1,3-Propanediamine | 5 | Sorbitol | 30 | 65 |
| 2I | Diethylenetriamine | 1 | Sorbitol | 10 | 89 |
| 2J | Triethylenetetramine | 1 | Sorbitol | 10 | 89 |

**TABLE 3**

| Examples | Transistor structure | Etching solution | Treating temperature/°C | Treating time/min | Evaluation | |
|---|---|---|---|---|---|---|
| | | | | | Etching condition of polysilicon | Corrosion resistance to aluminum |
| 1 | 1A | 2G | 25 | 2 | ○ | ○ |
| 2 | 1B | 2G | 25 | 2 | ○ | ○ |
| 3 | 1C | 2G | 25 | 2 | ○ | ○ |
| 4 | 1D | 2G | 25 | 2 | ○ | ○ |
| 5 | 1E | 2G | 25 | 2 | ○ | ○ |
| 6 | 1F | 2G | 25 | 2 | ○ | ○ |
| 7 | 1G | 2G | 25 | 2 | ○ | ○ |
| 8 | 1H | 2G | 25 | 2 | ○ | ○ |
| 9 | 1I | 2G | 25 | 2 | ○ | ○ |
| 10 | 1A | 2H | 25 | 2 | ○ | ○ |
| 11 | 1B | 2H | 25 | 2 | ○ | ○ |
| 12 | 1C | 2H | 25 | 2 | ○ | ○ |
| 13 | 1D | 2H | 25 | 2 | ○ | ○ |
| 14 | 1E | 2H | 25 | 2 | ○ | ○ |
| 15 | 1F | 2H | 25 | 2 | ○ | ○ |
| 16 | 1G | 2H | 25 | 2 | ○ | ○ |
| 17 | 1H | 2H | 25 | 2 | ○ | ○ |
| 18 | 1I | 2H | 25 | 2 | ○ | ○ |
| 19 | 1A | 2I | 25 | 3 | ○ | ○ |
| 20 | 1B | 2I | 25 | 3 | ○ | ○ |
| 21 | 1C | 2I | 25 | 3 | ○ | ○ |
| 22 | 1D | 2I | 25 | 3 | ○ | ○ |
| 23 | 1E | 2I | 25 | 3 | ○ | ○ |
| 24 | 1F | 2I | 25 | 3 | ○ | ○ |
| 25 | 1G | 2I | 25 | 3 | ○ | ○ |
| 26 | 1H | 2I | 25 | 3 | ○ | ○ |
| 27 | 1I | 2I | 25 | 3 | ○ | ○ |
| 28 | 1A | 2A | 25 | 4 | ○ | ○ |
| 29 | 1A | 2B | 25 | 2 | ○ | ○ |
| 30 | 1A | 2C | 25 | 3 | ○ | ○ |
| 31 | 1A | 2D | 25 | 2 | ○ | ○ |
| 32 | 1A | 2E | 25 | 2 | ○ | ○ |
| 33 | 1A | 2F | 25 | 2 | ○ | ○ |
| 34 | 1A | 2J | 25 | 2 | ○ | ○ |
| 35 | 1B | 2A | 25 | 4 | ○ | ○ |
| 36 | 1B | 2B | 25 | 2 | ○ | ○ |
| 37 | 1B | 2C | 25 | 3 | ○ | ○ |
| 38 | 1B | 2D | 25 | 2 | ○ | ○ |
| 39 | 1B | 2E | 25 | 2 | ○ | ○ |
| 40 | 1B | 2F | 25 | 2 | ○ | ○ |
| 41 | 1B | 2J | 25 | 2 | ○ | ○ |
| 42 | 1C | 2A | 25 | 4 | ○ | ○ |
| 43 | 1C | 2B | 25 | 2 | ○ | ○ |
| 44 | 1C | 2C | 25 | 3 | ○ | ○ |
| 45 | 1C | 2D | 25 | 2 | ○ | ○ |
| 46 | 1C | 2E | 25 | 2 | ○ | ○ |
| 47 | 1C | 2F | 25 | 2 | ○ | ○ |
| 48 | 1C | 2J | 25 | 2 | ○ | ○ |

**TABLE 4**

| Etching solution | Composition of etching solution (conc.: wt%) |
|---|---|
| 4A | Tetramethyl ammonium hydroxide: 2%; water: 98% |
| 4B | Tetramethyl ammonium hydroxide: 0.5%; silicon: 0.1%; water: 99.4% |
| 4C | Tetramethyl ammonium hydroxide: 10%; hydroxyl amine: 10%; sorbitol: 5%; water: 75% |
| 4D | Tetramethyl ammonium hydroxide: 2.4%; sorbitol: 5%; water: 92.6% |
| 4E | Hexamethylenediamine (1,6-hexadiamine): 5%; sorbitol: 30%; water: 65% |
| 4F | Tetramethyl ammonium hydroxide: 4%; trimethylamine: 0.01%; propylene glycol: 80%; glycerin: 4%; water: 11.99% |
| 4G | 1,3-Propanediamine: 0.5%; water: 99.5% |
| 4H | Sorbitol: 10%; water: 90% |
| 4I | 1,3-Propanediamine: 5%; inositol: 10%; water: 85% |
| 4J | 1,3-Propanediamine: 5%; sucrose: 10%; water: 85% |

**TABLE 5**

| Comparative Examples | Transistor structure | Etching solution | Treating temperature/°C | Treating time/min | Evaluation | |
|---|---|---|---|---|---|---|
| | | | | | Etching condition of silicon | Corrosion resistance to aluminum |
| 1 | 1D | 4A | 25 | 2 | × | × |
| 2 | 1B | 4B | 25 | 2 | × | ○ |
| 3 | 1C | 4C | 25 | 2 | ○ | × |
| 4 | 1G | 4D | 25 | 2 | × | × |
| 5 | 1E | 4E | 25 | 2 | × | ○ |
| 6 | 1I | 4F | 25 | 2 | × | ○ |
| 7 | 1F | 4G | 25 | 2 | × | × |
| 8 | 1H | 4H | 25 | 2 | × | ○ |
| 9 | 1A | 4I | 25 | 2 | ○ | × |
| 10 | 1A | 4J | 25 | 2 | ○ | × |

### INDUSTRIAL APPLICABILITY

The etching solution according to the preset invention is capable of selectively etching a dummy gate made of silicon without etching an aluminum metal gate, an interlayer insulating film, a side wall and a high dielectric material film. For this reason, the etching solution can be used in the process for producing a transistor containing a high dielectric material film and an aluminum-containing metal gate and therefore is useful from the industrial viewpoints.

## Claims

1. A silicon etching solution for etching a dummy gate made of silicon in a process for producing a transistor using a structural body comprising a substrate, and a dummy gate laminate formed by laminating at least a high dielectric material film and the dummy gate made of silicon, a side wall disposed to cover a side surface of the laminate and an interlayer insulating film disposed to cover the side wall which are provided on the substrate, in which the dummy gate is replaced with an aluminum metal gate,
said silicon etching solution comprising 0.1 to 40% by weight of at least one alkali compound selected from the group consisting of ammonia, a diamine and a polyamine represented by the following general formula (1), 5 to 50% by weight of at least one polyhydric alcohol represented by the following general formula (2) and 40 to 94.9% by weight of water:
H₂N-(CH₂CH₂NH)ₘ-H (1)
wherein m is an integer of 2 to 5; and
H-(CH(OH))ₙ-H (2)
wherein n is an integer of 3 to 6.

2. The silicon etching solution according to claim 1, wherein the diamine and the polyamine represented by the general formula (1) are at least one compound selected from the group consisting of ethylenediamine, 1,2-propanediamine and 1,3-propanediamine, and at least one compound selected from the group consisting of diethylenetriamine and triethylenetetramine, respectively.

3. The silicon etching solution according to claim 1, wherein the polyhydric alcohol represented by the general formula (2) is at least one compound selected from the group consisting of glycerin, meso-erythritol, xylitol and sorbitol.

4. The silicon etching solution according to claim 1, wherein a high dielectric material forming the high dielectric material film is HfO₂, HfSiO, HfSiON, HfLaO, HfLaON, HfTiSiON, HfAlSiON, HfZrO or Al₂O₃.

5. A process for producing a transistor using a structural body comprising a substrate, and a dummy gate laminate formed by laminating at least a high dielectric material film and a dummy gate made of silicon, a side wall disposed to cover a side surface of the laminate and an interlayer insulating film disposed to cover the side wall which are provided on the substrate,
said process comprising the following step (I) so that the dummy gate is replaced with an aluminum metal gate:
Step (I): etching the silicon with an etching solution comprising 0.1 to 40% by weight of at least one alkali compound selected from the group consisting of ammonia, a diamine and a polyamine represented by the following general formula (1), 5 to 50% by weight of at least one polyhydric alcohol represented by the following general formula (2) and 40 to 94.9% by weight of water:
H₂N-(CH₂CH₂NH)ₘ-H (1)
wherein m is an integer of 2 to 5; and
H-(CH(OH))ₙ-H (2)
wherein n is an integer of 3 to 6.

6. The process for producing a transistor according to claim 5, wherein a high dielectric material forming the high dielectric material film is HfO₂, HfSiO, HfSiON, HfLaO, HfLaON, HfTiSiON, HfAlSiON, HfZrO or Al₂O₃.

7. The process for producing a transistor according to claim 5, wherein the diamine and the polyamine represented by the general formula (1) are at least one compound selected from the group consisting of ethylenediamine, 1,2-propanediamine and 1,3-propanediamine, and at least one compound selected from the group consisting of diethylenetriamine and triethylenetetramine, respectively.

8. The process for producing a transistor according to claim 5, wherein the polyhydric alcohol represented by the general formula (2) is at least one compound selected from the group consisting of glycerin, meso-erythritol, xylitol and sorbitol.
